Europäisches Patentamt

**European Patent Office**

Office européen des brevets

(19)

(11) Veröffentlichungsnummer: **0 005 728**
**B1**

(12) **EUROPÄISCHE PATENTSCHRIFT**

(45) Veröffentlichungstag der Patentschrift: **03.02.82**

(21) Anmeldenummer: **79101267.7** .

(22) Anmeldetag: **26.04.79**

(51) Int. Cl.³: **H 01 L 27/08,**
**H 01 L 29/72, H 01 L 21/76.**

(54) **Verfahren zum Herstellen eines lateralen PNP- oder NPN-Transistors mit hoher Verstärkung und dadurch hergestellter Transistor.**

(30) Priorität: **25.05.78 US 909338**

(43) Veröffentlichungstag der Anmeldung:
**12.12.79 Patentblatt 79/25**

(45) Bekanntmachung des Hinweises auf die Patenterteilung:
**03.02.82 Patentblatt 82/5**

(84) Benannte Vertragsstaaten:
**DE FR GB** .

(56) Entgegenhaltungen:
**DE - A - 2 617 483** ·
**DE - A - 2 651 449** ·
**EP - A - 0 000 897** ·
**US - A - 3 891 480** ·
**US - A - 3 966 577**

(73) Patentinhaber: **International Business Machines Corporation**
**Armonk, N.Y. 10504 (US)** ·

(72) Erfinder: **Anantha, Narasipur Gundappa**
**1 Valdemar Road**
**Hopewell Junction, NY 12533 (US)**
Erfinder: **Bhatia, Harsaran Singh**
**41 Tor Road**
**Wappingers Falls, NY 12590 (US)**
Erfinder: **Gaur, Santosh Prasad**
**23C Carnaby Street**
**Wappingers Falls, NY 12590 (US)**
Erfinder: **Pogge, Hans Bernhard**
**R.D. No.3, LaDue Road**
**Hopewell Junction, NY 12533 (US)**

(74) Vertreter: **Böhmer, Hans Erich, Dipl.-Ing.**
**Schönaicher Strasse 220**
**D-7030 Böblingen (DE)**

Courier Press, Leamington Spa, England.

(56) Entgegenhaltungen:

IEEE JOURNAL OF SOLID-STATE CIRCUITS,
Band SC-11, Juni 1976,
New York, USA
C. MULDER und H. E. J. WULMS: "High speed
integrated injection logic ($I^2L$)", Seiten 379 ·
bis 385

IBM TECHNICAL DISCLOSURE BULLETIN,
Band 20, März 1978,
New York, USA
H. I. STOLLER: "Bipolar integrated circuit
devices defined by recessed dielectric isolation
of varying depths, Seiten 3901 bis 3902 ·

# Verfahren zum Herstellen eines lateralen PNP- oder NPN-Transistors mit hoher Verstärkung und dadurch hergestellter Transistor

Die Erfindung betrifft ein Verfahren zum Herstellen von lateralen PNP- oder NPN-Transistoren mit hoher Verstärkung und dadurch hergestellte Transistoren. Insbesondere sollen durch die Erfindung laterale, bipolare Transistoren, nämlich insbesondere laterale PNP- oder NPN-Transistoren gebildet werden.

In der Technik der monolithischen integrierten Schaltungen ist es normalerweise erforderlich, verschiedene aktive und passive Elemente in einer integrierten Schaltung gegeneinander zu isolieren. Man hat diese Isolation beispielsweise durch in Sperrichtung vorgespannte PN-Übergänge, durch teilweise dielektrische Isolierung oder vollständige dielektrische Isolierung vorgenommen. Die dazu verwendeten dielektrischen Materialien waren Siliciumdioxid, Glas usw. Die bevorzugte Isolation für diese aktiven Bauelemente und Schaltungen ist dabei eine Art der dielektrischen Isolation. Die dielektrische Isolation hat gegenüber dem in Sperrichtung vorgespannten PN-Übergang den wesentlichen Vorteil, daß sich die einzelnen Bauelemente oder Schaltelemente unmittelbar an die Isolation anschließen können, so daß man eine größere Packungsdichte der aktiven und passiven Bauelemente auf dem integrierte Schaltungen enthaltenden Halbleiterplättchen erzielen kann. Eine Art der dielektrischen Isolation wird dadurch hergestellt, daß man an der Stelle, an der die Isolationszonen gebildet werden sollen, in dem Siliciumsubstrat Vertiefungen anbringt. Bei der Herstellung solcher Vertiefungen wird die restliche Oberfläche des Siliciumsubstrats durch eine Schutzschicht abgedeckt, die im wesentlichen durch das Silicium ätzende Ätzmittel bei der Bildung der Vertiefungen nicht angegriffen wird. Die gewöhnlicherweise verwendete Schutzschicht besteht aus zwei Schichten aus Siliciumnitrid und Siliciumdioxid. Nach Herstellung der Vertiefungen durch ein übliches chemisches Ätzverfahren oder durch reaktives Ionenätzen, wird das Siliciumsubstrat einer Oxidation unterzogen, wobei das in der Vertiefung liegende Silicium oxydiert wird. Diese Vertiefungen können dann anschließend durch eine weitere thermische Oxidation, durch Niederschlagen eines polykristallinen Siliciums oder durch einen Niederschlag aus der Dampfphase eines dielektrischen Materials, wie z. B. Siliciumdioxid oder Siliciumnitrid aufgefüllt werden.

Die Europäische Patentanmeldung 78100614 beschreibt ein verbessertes Verfahren zum Herstellen einer dielektrischen Isolation, bei der Vertiefungen mit dielektrischem Material ausgefüllt sind. In dem dort beschriebenen bevorzugten Ausführungsbeispiel war es erforderlich, die Vertiefungen durch eine $N^+$-leitende Zone hindurch, die später die Subkollektorzone für die bipolaren Bauelemente werden sollte, durch reaktives Ionenätzen herzustellen. Dies ergab Schwierigkeiten, weil die $N^+$-leitende Zone unter bestimmten Betriebsbedingungen beim reaktiven Ionenätzen zu Unterschneidungen eines Teils des monokristallinen Materials oberhalb der $N^+$-leitenden Zone führen kann. Dies wird für sehr unerwünscht gehalten. Bei der Herstellung von integrierten Schaltungen, bei denen eine Anzahl von PNP-Transistoren und NPN-Transistoren im gleichen Halbleiterkörper hergestellt werden sollen, gab es bisher kein praktisch brauchbares Verfahren für die Herstellung von vertikalen NPN- und vertikalen PNP-Transistoren. Wenn man solche Transistoren hergestellt hat, mußten Kompromisse bezüglich der elektrischen Kennwerte der Transistoren eingegangen werden. Diese Kompromisse haben bei PNP-Transistoren normalerweise eine niedrige Stromverstärkung und einen hohen Sättigungswiderstand zur Folge. Daher ist das Betriebsverhalten eines derartigen PNP-Transistors im Vergleich mit einem NPN-Transistor wesentlich schlechter.

Ein Versuch zur Überwindung dieser Schwierigkeiten bei der Herstellung von PNP-Transistoren und NPN-Transistoren in einem einzigen Halbleiterkörper bestand darin, einen vertikalen NPN-Transistor gleichzeitig mit einem lateralen PNP-Transistor herzustellen. Bei dem lateralen Aufbau stellt eine N-leitende Epitaxieschicht normalerweise die Basis dar, während Emitter und Kollektorzonen mit Abstand in der Basiszone eingelagert sind. Emitter- und Kollektorzonen des lateralen PNP-Transistors können während der Diffusionsverfahrensschritte zur Bildung der Basiszone des doppelt diffundierten NPN-Transistors gebildet werden. Damit entfallen aber nach der Herstellung des NPN-Transistors alle Hochtemperatur-Verfahrensschritte. Der durch dieses Verfahren hergestellte laterale PNP-Transistor weist jedoch zwei wesentliche Nachteile auf, die darin bestehen, daß die Stromverstärkung (Beta) des Transistors sehr gering ist und daß das Beta mit zunehmendem Emitterstrom sehr rasch abfällt. Bei einer kleinen Spannung zwischen Emitter und Basis erfolgt die Ladungsträgerinjektion im wesentlichen in die Zone zwischen Emitter und Kollektor, und die Ladungsträger werden durch den Kollektor abgeführt, wodurch sich eine hohe Verstärkung ergibt. Bei höheren Basis-Emitter-Spannungen wird jedoch der vertikale Übergang zwischen Emitter- und Basiszone in Durchlaßrichtung entsperrt, so daß man einen übermäßig hohen Basisstrom und niedrige Stromverstärkung (Beta) erhält.

Die US-Patentschrift 3 971 059 offenbart die Bildung komplementärer Bauelemente aus vertikalen NPN-Transistoren und lateralen PNP-Transistoren.

In der Deutschen Patentanmeldung P 21 01 279.3 ist ein weiteres Verfahren beschrieben, wie die Stromverstärkung in einem lateralen PNP-Transistor verbessert werden kann.

Der Erfindung liegt daher die Aufgabe zugrunde, ein Verfahren der eingangsgenannten Art anzugeben durch welches bei der Herstellung von lateralen PNP- oder NPN-Transistoren eine hohe Stromverstärkung erzielt werden kann, und dies insbesondere auch bei gleichzeitiger Herstellung von vertikalen NPN bzw. PNP-Transistoren in isolierten Bereichen des Halbleitersubstrats.

Dies wird erfindungsgemäß durch folgende Verfahrensschritte erreicht:

Bilden einer ersten $N^+$ (bzw. $P^+$)-leitenden Schicht in einem Halbleiterkörper; epitaxiales Aufwachsen einer zweiten N-(P)-leitenden monokristallinen Siliciumschicht auf der ersten Schicht; Herstellen von die zweite und erste Schicht durchsetzenden Vertiefungen durch reaktives Ionenätzen in solchen Bereichen des Halbleiterkörpers, in denen eine dielektrische Isolationszone für die Isolierung von Zonen der zweiten Schicht gebildet werden soll, wobei die Ätzgeschwindigkeit der reaktiven Ionenätzung so eingestellt wird, daß die erste Schicht bevorzugt geätzt wird, so daß eine Unterätzung der zweiten Schicht auftritt; Auffüllen der Vertiefungen mit einem dielektrischen Material in der Weise, daß unter den unterätzten Bereichen der zweiten Schicht dielektrisches Material abgelagert wird, gleichzeitige Bildung P-(bzw. N)-leitender Emitter- und Kollektorzonen, wobei die Emitterzone in dem Teil des monokristallinen Siliciums gebildet wird, unter dem die dielektrische Isolation liegt, so daß zwischen der P-(bzw. N)-leitenden Emitterzone und der vergrabenen $N^+$-(bzw. $P^+$)-leitenden Zone kein vertikaler Schichtübergang entsteht; und Herstellen von elektrischen Kontakten an die Emitter-, Basis- und Kollektorzone zur Bildung eines lateralen PNP-(bzw. NPN)-Transistors.

Gleichzeitig mit der Bildung eines lateralen PNP-Transistors kann auch ein NPN-Transistor gebildet werden, oder es kann gleichzeitig ein lateraler NPN-Transistor zusammen mit einem vertikalen PNP-Transistor hergestellt werden.

Durch das soeben geschilderte Verfahren wird also ein lateraler PNP- oder NPN-Transistor mit einer monokristallinen Siliciumzone gebildet, die von anderen derartigen monokristallinen Zonen durch eine dielektrische Isolationszone isoliert ist. Diese dielektrische Isolation erstreckt sich teilweise in die monokristalline Siliciumzone unterhalb der Oberfläche dieser Siliciumzone hinein. Die Emitterzone liegt oberhalb dieser teilweise in die Siliciumzone sich hinein erstreckenden Isolation. P- oder N-leitende Kollektorzonen und N- oder P-leitende Basiszonen liegen ebenfalls innerhalb der Siliciumzonen. Zur Bildung von lateralen PNP- oder NPN-Transistoren werden elektrische Kontakte an die Emitter-, Basis- und Kollektorzone hergestellt.

Die Erfindung wird nunmehr anhand eines Ausführungsbeispiels in Verbindung mit den beigefügten Zeichnungen im einzelnen beschrieben.

In den Zeichnungen zeigt

Fig. 1 einen lateralen PNP-Transistor gemäß dem Stande der Technik,

Fign. 2—5 die einzelnen Verfahrensschritte zur Herstellung eines lateralen PNP-Transistors nach dem erfindungsgemäßen Verfahren und

Fig. 6 einen vertikalen NPN- und einen lateralen PNP-Transistor, die nach dem erfindungsgemäßen Verfahren hergestellt sind.

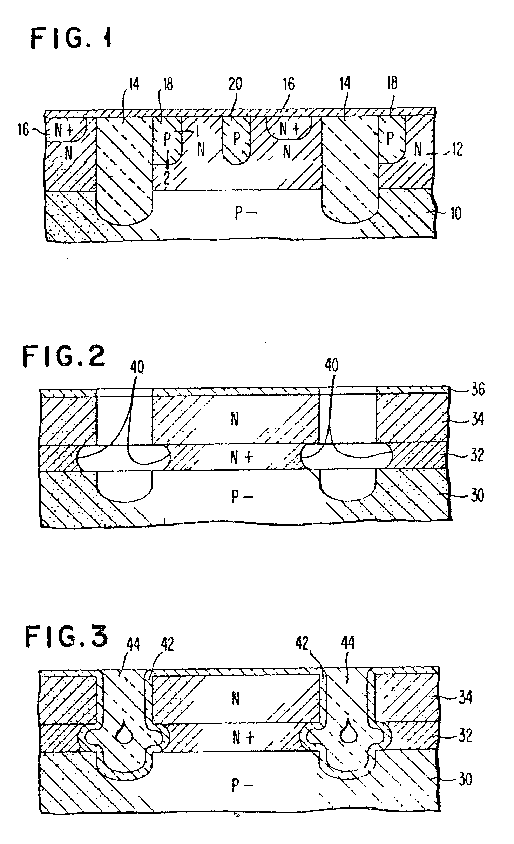

Fig. 1 zeigt einen PNP-Transistor gemäß dem Stande der Technik. In einem monokristallinen P-leitenden Siliciumsubstrat 10 mit darüber gebildeter N-leitender Epitaxieschicht 12 ist ein Isolierbereich 14 vorgesehen, der eine Zone aus monokristallinem Silicium vollständig umgibt. In Fig. 1 besteht die Isolationszone 14 aus dielektrischem Material. Die Epitaxieschicht 12 stellt dabei die Basiszone dar, und der dafür erforderliche Basiskontakt wird durch eine $N^+$-leitende Diffusionszone 16 gebildet. Die Emitterzone 18 und die Kollektorzone 20 können zur gleichen Zeit hergestellt werden. Bei der niedrigen Emitter-Basis-Spannung erfolgt die Strominjektion im wesentlichen in den Bereich 1, wie dies durch einen Pfeil angedeutet ist. Dieser Strom fließt nach der Kollektorzone 20, was eine hohe Stromverstärkung (Beta) zur Folge hat. Bei höheren Emitter-Basis-Spannungen wird der vertikale Schichtübergang zur Zone 2 entsperrt, so daß ein übermäßig hoher Basisstrom fließt und nur eine geringe Verstärkung (Beta) erzielbar ist.

In den Fign. 2 bis 5 sind die verschiedenen Verfahrensschritte bei der Herstellung der dielektrischen Isolation einer Ausführungsform der Erfindung dargestellt. Die in Fig. 2 dargestellte Struktur besteht aus einem monokristallinen P-leitenden Siliciumsubstrat 30, einer darüber liegenden $N^+$-leitenden Schicht 32 und einer über dieser $N^+$-leitenden Schicht 32 liegenden N-leitenden Schicht 34. Vorzugsweise soll die Schicht 32 eine sehr gute Leitfähigkeit aufweisen, da sie schließlich als Kollektor eines bipolaren NPN-Transistors dienen soll und da außerdem dadurch beim reaktiven Ionenätzen eine Unterschneidung oder Unterätzung der darüber liegenden monokristallinen Zone möglich sein soll. Diese Struktur kann auf verschiedene Weise hergestellt werden. Das bevorzugte Verfahren besteht jedoch darin, ein P-leitendes monokristallines Siliciumsubstrat einzusetzen und eine $N^+$-leitende alles überdeckende Diffusion in das Substrat in der Weise durchzuführen, daß entweder durch Diffusion oder durch Ionenimplantation eines N-leitenden Störelements, wie z. B. Arsen, Antimon oder Phosphor eine $N^+$-leitende Zone gebildet wird, deren Oberflächenkonzentration zwischen $1 \times 10^{19}$ oder $1 \times 10^{21}$ Atome/ccm liegt. Anschließend wird darüber die Schicht 34 epitaxial aufgewachsen.

Dies kann durch bekannte Verfahren, wie z. B. durch die Verwendung von $SiCl_4/H_2$ oder $SiH_4/H_2$-Mischungen bei Temperaturen von etwa 1000°C bis 1200°C durchgeführt werden. Die $N^+$-leitende Schicht kann dabei eine Dicke von 1 bis 3 Mikrometer aufweisen, während die epitaxial aufgewachsene Schicht eine Stärke von 0,5 bis 10 Mikrometer aufweisen kann, wobei die genaue Dicke von der Art der herzustellenden Bauelemente abhängt.

Andererseits könnte man diese Struktur auch durch verschiedene Kombinationen von Thermodiffusion, Ionenimplantation und/oder epitaxialem Aufwachsen von Schichten, zusammen mit der Bildung einer vergrebenen Subkollektorzone herstellen, wenn die spätere Bildung von bipolaren Transistoren erwünscht sein sollte.

Die nächsten Verfahrensschritte, die mit Hilfe von Fig. 2 erläutert werden sollen, bestehen darin, durch reaktives Ionenätzen Vertiefungen in der Siliciumstruktur herzustellen. Dann wird durch übliche Verfahren, die entweder thermisches Aufwachsen bei Temperaturen von etwa 900°C bis 1000°C in einer nassen oder trockenen Sauerstoffatmosphäre oder durch chemischen Niederschlag aus der Dampfphase einer Siliciumdioxid-Schicht 36 gebildet. Andere Maskenmaterialien, wie z. B. Siliciumnitrid und Aluminiumoxid oder deren Kombinationen können ebenso eingesetzt werden. Die Öffnungen werden in dem Oxid in denjenigen Bereichen hergestellt, in denen eine dielektrische Isolation gewünscht wird. Diese Öffnungen werden durch übliche photolithographische Verfahren und durch Ätzung hergestellt.

Die mit Öffnungen in der Schicht 36 versehene Struktur kann nunmehr einem reaktiven Ionenätzverfahren ausgesetzt werden. Das durch Hochfrequenz angeregte Plasma ist reaktives Chlor, Brom oder Jod, wie dies in der Deutschen Patentanmeldung P 26 17 483.4 angegeben ist. Die Dicke der Maskenschicht 36 beträgt zwischen 200 und 2000 Nanometer, wobei die genaue Stärke dieser Schicht von der erforderlichen Tiefe der in den Siliciumkörper einzuätzenden Vertiefung abhängt. Eine genaue Beschreibung der mit Hochfrequenz-Glimmentladung arbeitenden Ätzvorrichtung ist in der oben angegebenen Patentanmeldung enthalten. Die zum reaktiven Ionenätzen oder Plasmaätzen verwendete Atmosphäre ist vorzugsweise eine Kombination eines inerten Gases, wie z. B. Argon mit Chlor. Durch geeignete Wahl der Leistung einer Hochfrequenzquelle zwischen etwa 0, 1 bis 0,75 Watt/$cm^2$ erhält man eine ausreichend hohe Energiedichte, so daß das reaktive Ionenätzen in dem Silicium mit einer Ätzgeschwindigkeit von etwa 0,02 bis 0,08 Mikrometer je Minute abläuft. Das gewünschte Ergebnis dieser Ätzung ist in Fig. 2 gezeigt, wo die Vertiefungen mindestens zum Teil in das P-leitende Substrat 30 hineinreichen, wobei Teile des entfernten $N^+$-leitenden Bereichs 32 zu unterätzten Bereichen 40 unterhalb der Epitaxieschicht 34 geführt haben. Die Vertiefungen gehen dabei vorzugsweise voll durch die $N^+$-leitende Schicht 32 hindurch.

Die oben erwähnte Europäische Patentanmeldung 78100614. beschreibt dabei ein Verfahren zum Herstellen von Vertiefungen, deren Seitenwände mit einem Winkel von mehr als 2° gegen die Vertikale geneigt sind. Der Grund dafür ist darin zu sehen, daß das anschließende Auffüllen mit dielektrischem Material einen geringfügig dickeren Niederschlag am oberen Ende der Verteifung liefert, verglichen mit dem unteren Ende der Vertiefung. Bei Vertiefungen mit genau senkrechten Seitenwänden erhält man zu einem bestimmten Zeitpunkt ein Zusammenwachsen des verbleibenden schmalen Spaltes, so daß in dem Bereich unterhalb dieses zugewachsenen Spaltes das dielektrische Material von geringer Qualität ist. Wenn der Spalt eine ausreichende Neigung der Seitenwände aufweist, dann wird der Spalt von seinem unteren Ende an aufgefüllt.

Eine Veränderung der Ätzgeschwindigkeiten, der eingesetzten Leistung, des reaktiven Materials und der Menge des reaktiven Materials in der Atmosphäre beeinflußt die Unterätzung der hoch dotierten $N^+$-leitenden und $P^+$-leitenden Bereiche, wie z. B. die Schicht 32. Bei Ätzgeschwindigkeiten von etwa 0,07 mikrometer je Minute bilden sich vertikale Vertiefungen ohne seitliches Unterätzen in die $N^+$-leitende Schicht hinein, wie dies in der oben genannten Europäischen Patentanmeldung dargelegt ist.

Bei Ätzgeschwindigkeiten von mehr als 0,07 Mikrometer je Minute bis etwa 0,20 Mikrometer je Minute erhält man jedoch eine merkliche Unterätzung der $N^+$-leitenden Schicht, vorausgesetzt die Energiedichte der Ätzvorrichtung liegt im Bereich zwischen 0,1 bis 0,5 Watt/$cm^2$ und der gesamte Gasdruck beträgt etwa 0,0133 bis 0,0532 mbar. Die Kathode ist wassergekühlt, und es wird keine besondere thermische Kontaktierung der Halbleiterscheibe mit dieser Kathode benutzt. Andererseits kann die Unterätzung auch dadurch begünstigt werden, daß man das Substrat auf 100°C bis 200°C aufheizt. Unter diesen Bedingungen kann die notwendige Ätzgeschwindigkeit geringer sein als 0,07 Mikrometer je Minute. Es wurde ebenso festgestellt, daß anstelle der $N^+$-leitenden Schicht eine $P^+$-leitende Schicht in genau der gleichen Weise unter gleichen Bedingungen, wie sie für eine Unterätzung der $N^+$-leitenden Schicht angegeben wurden, unterätzt werden kann.

Der nächste Verfahrensschritt gemäß Fig. 3 besteht darin, die Vertiefungen dadurch thermisch zu oxidieren, daß der Halbleiterkörper einer oxidierenden Atmosphäre ausgesetzt wird, die z. B. nasser Sauerstoff bei 970°C sein kann. Der Halbleiterkörper wird dieser Atmosphäre für etwa 10 bis 30 minuten ausgesetzt und liefert vorzugsweise eine Siliciumdioxid-Schicht mit einer Schichtdicke innerhalb der Vertiefung von etwa 50 bis 200 Nanometer. Der Zweck dieser thermisch aufgewachsenen Oxidschicht 42 besteht darin, sicherzustellen, daß die Trennschicht zwischen Silicium und Siliciumdioxid die erforderlichen guten Eigenschaften aufweist, wobei diese Eigenschaften normalerweise mit chemisch aus der Dampfphase niedergeschlagenem dielektrischem Material nicht so gut sind. An dieser Stelle ist es notwendig, daß dielektrisches Material von guter Qualität vorhanden ist, damit anschließend eindiffundierte Schichtübergänge an dieser dielektrischen Isolation anstoßen können.

Zur Bildung einer guten thermischen Siliciumdioxid-Schicht muß die Dicke mindestens 50 Nanometer betragen. Eine dünnere Schicht könnte Schwierigkeiten verursachen, da in der Schicht feinste Löcher, sogenante "Pin Holes" auftreten können und damit die elektrischen Eigenschaften ungenügend sein könnten.

Die größte Dicke wird normalerweise durch die bei erhöhten Temperaturen erforderliche Zeit bestimmt. Ein über lange Zeit bei hohen Temperaturen durchgeführter Verfahrensschritt kann zur Folge haben, daß ein endiffundierter Schichtübergang innerhalb der Siliciumbereiche verschoben wird. Bei solchen Temperaturen gebildete, sehr dicke Oxidschichten können außerdem auf das Silicium-material Spannungen ausüben.

Die aufgewachsene Oxidschicht 42 folgt dabei fast genau den Abmessungen der Seitenwände in der durch das reaktive Ionenätzen hergestellten Vertiefung. Beim nächsten Verfahrensschritt, bei dem die Vertiefung mit einem geeigneten dielektrischen Material aufgefüllt wird, ist in Fig. 3 als bereits abgeschlossen dargestellt, wobei die Vertiefung mit einer aus der Dampfphase niedergeschlagenen Siliciumdioxid-Schicht 44 aufgefüllt ist. Diese zum Auffüllen aus der Dampfphase niedergeschlagene Siliciumdioxid-Schicht 44 folgt dabei im allgemeinen den Umrissen der Vertiefung, so daß die Vertiefung an der Oberseite vollkommen geschlossen ist, während im mittleren Bereich der Vertiefung in der Tiefe der unterätzten $N^+$-leitenden Zone ein in Fig. 3 angedeuteter Hohlraum verbleiben wird. Der Niederschlag aus der Dampfphase überdeckt außerdem die Oberfläche des Siliciumkörpers vollständig. Das bevorzugte Verfahren zum Auffüllen der Vertiefung ist der chemische Niederschlag von Siliciumdioxid aus der Dampfphase unter Verwendung von Gasmischungen aus $SiH_4/CO_2/H_2$, $SiH_4/N_2O/N_2$ oder $SiCl_2H_2/N_2O$ im Temperaturbereich von 800 bis 1000°C.

Weitere Einzelheiten des Verfahrens zum Auffüllen der Vertiefungen und zum Herstellen einer gleichmäßigen Oberfläche gemäß Fig. 3 sind in der genannten Europäischen Patentanmeldung zu finden.

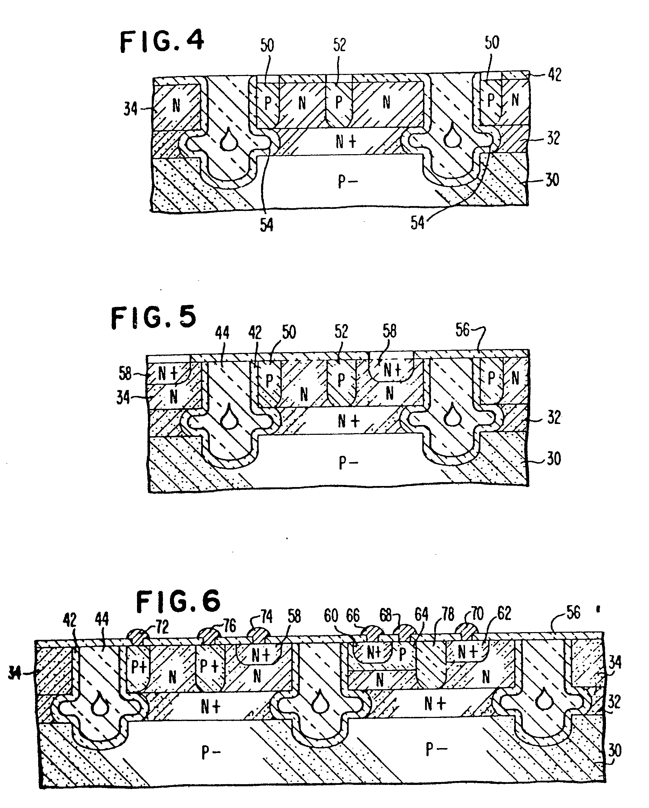

Gemäß Fig. 4 werden durch übliche photolithographische Verfahren auf der Oberfläche der Siliciumdioxid-Schicht 42 eine Photolackmaske aufgebracht mit Öffnungen an den Stellen, wo die Emitter- und Kollektordiffusion 50 bzw. 52 gebildet werden soll. Diese Zonen 50 und 52 können durch Diffusion oder durch Ionenimplantation hergestellt werden. Für die Ionenimplantation wird vorzugsweise Bor als Implantationsmaterial mit einer Dosierung von $1 \times 10^{14}$ Atome/$cm^2$ verwendet, wobei die erforderliche Leistung 80 KeV beträgt. Die sich dabei ergebende Struktur zeigt Fig. 4, bei der die P-leitenden Emitterzonen 50 in dem monokristallinen Siliciumbereich oberhalb des dielektrischen Materials 54 liegen, so daß auf diese Weise der vertikale PN-Übergang des Standes der Technik gemäß Fig. 1 vollständig beseitigt ist. Die Oberfläche wird reoxydiert, und es werden durch Verwendung üblicher photolithographischer Verfahren Öffnungen in der Siliciumschicht 56 an der Stelle gebildet, wo der Basiskontakt, der in Fig. 5 gezeigt ist, hergestellt werden soll. Die Struktur wird dabei zur Herstellung des Basiskontakts 58 in einen Diffusionsapparat oder einen Ionenimplantationsapparat eingebracht. Bei Ionenimplantation wird vorzugsweise Arsen mit einer Dosierung von $3 \times 10^{15}$ Atomen/$cm^2$ verwendet und die dafür erforderliche Leistung beträgt 40 KeV. Die sich ergebende Struktur zeigt Fig. 5. Die Oberfläche des Halbleiterkörpers ist reoxidiert, und die elektrischen Kontakte sind an die lateralen PNP-Transistoren hergestellt.

Fig. 6 zeigt eine vollständige Halbleiteranordnung mit elektrischen Kontakten für einen lateralen PNP-Transistor und einen vertikalen NPN-Transistor in der gleichen integrierten Schaltung in benachbarten monokristallinen Zonen. Bei der Herstellung der in Fig. 6 gezeigten Struktur kann man die Diffusion oder Ionenimplantation für den Basiskontakt, zur Bildung der Emitterzone 60 und der Kollektorzone 62 für den vertikalen NPN-Transistor heranziehen, der aus einer Emitterzone 60, einer Basiszone 64 und einer Kollektorzone 62 besteht. Zum Herstellen elektrischer Kontakte an die Zonen in dem monokristallinen Silicium wird ein geeignetes Kontaktmetall aufgedampft oder durch andere Mittel auf der äußeren Oberfläche der Struktur nach Bildung von Öffnungen in den entsprechenden Bereichen niedergeschlagen.

Ein geeignetes Kontaktmaterial ist z. B. Aluminium oder Aluminium-Kupfer. Andere bekannte Materialien, wie z. B. Platin, Titan-Wolfram und dergleichen können ebenfalls benutzt werden. Photolithographische und Ätzverfahren werden zur Herstellung der gewünschten Leitungszüge auf der Oberfläche der Halbleiterstruktur eingesetzt. Die in Fig. 6 gezeigte Struktur weist eine metallische Elektrode 66 für den Emitter des virtikalen Transistors, eine Elektrode 68 nach der Basis und eine Elektrode 70 nach dem Kollektor des vertikalen Transistors auf. Der laterale NPN-Transistor weist einen metallischen Kontakt 72 an die Emitterzone, einen metallischen Kontakt 74 an die Basiszone und einen metallischen Kontakt 76 an die Kollektorzone des Transistors auf. Zwischen der Kollektorzone 62 und der Basiszone 64 des vertikalen NPN-Transistors ist eine dielektrische Isolationszone 78 angeordnet. Diese Isolationszone 78 kann in ähnlicher Weise hergestellt werden, wie die dielektrische Isolationszone 44.

## Patentansprüche

1. Verfahren zum Herstellen von lateralen PNP-(bzw. NPN) Transistoren mit hoher Stromverstärkung in einem Halbleiterkörper, gekennzeichnet durch Bilden einer ersten $N^+$ (bzw. $P^+$)-leitenden Schicht (32) in einem Halbleiterkörper; epitaxiales Aufwachsen einer zweiten N-(P)-leitenden monokristallinen Siliciumschicht (34) auf der ersten Schicht; Herstellen von die zweite und erste Schicht durchsetzenden Vertiefungen durch reaktives Ionenätzen in solchen Bereichen des Halbleiterkörpers, in denen eine dielektrische Isolationszone für die Isolierung von Zonen der zweiten Schicht gebildet werden soll, wobei die Ätzgeschwindigkeit der reaktiven Ionenätzung so eingestellt wird, daß die erste Schicht (32) bevorzugt geätzt wird, so daß eine Unterätzung (40) der zweiten Schicht (34) auftritt,

Auffüllen der Vertiefungen mit einem dielektrischen Material (44) in der Weise, daß unter den unterätzten Bereichen der zweiten Schicht, dielektrisches Material abgelagert wird,

gleichzeitige Bildung P-(bzw. N)-leitender Emitter- (50) und Kollektorzonen, (52) wobei die Emitterzone in dem Teil des monokristallinen Siliciums gebildet wird, unter dem die dielektrische Isolation liegt, so daß zwischen der P-(bzw. N)-leitenden Emitterzone und der vergrabenen $N^+$-(bzw. $P^+$)-leitenden Zone kein vertikaler Schichtübergang entsteht, und

Herstellen von elektrischen Kontakten (72, 74, 76) an die Emitter-, Basis- und Kollektorzone zur Bildung eines lateralen PNP-(bzw. NPN)-Transistors.

2. Verfahren nach Anspruch 1, dadurch gekennzeichnet daß in dem Halbleiterkörper für den Basiskontakt des PNP-(bzw. NPN)-Transistors eine $N^+$-(bzw. $P^+$)-leitende Zone gebildet wird.

3. Verfahren nach Anspruch 1, dadurch gekennzeichnet, daß das unter der Zweite Schicht (34) liegende dielektrische Material etwa 1 bis 3 Mikrometer dick ist.

4. Verfahren nach Anspruch 1, dadurch gekennzeichnet, daß das reaktive Ionenätzen in einer Chlor-Argon-Atmosphäre durchgeführt wird.

5. Verfahren nach Anspruch 4, dadurch gekennzeichnet daß das Chlor in der Atmosphäre mit einem Druck von 0,00266 bis 0,00665 mbar mit einem Anteil von 2 bis 15% verwendet wird und

daß die Ätzgeschwindigkeit zwischen etwa 0,07 und 20 Mikrometer je Minute beträgt.

6. Verfahren nach Anspruch 1, dadurch gekennzeichnet, daß die Abmessungen der Emitterzone etwa 1 × 1 bis 3 × 3 Mikrometer betragen.

7. Verfahren nach Anspruch 1, dadurch gekennzeichnet daß gleichzeitig mit den lateralen PNP-(bzw. NPN)-Transistoren mindestens in einer weiteren, isolierten Siliciumzone ein vertikaler NPN-(bzw. PNP)-Transistor dadurch gebildet wird, daß gleichzeitig mit dem Emitter (60) des NPN-(bzw. PNP)-Transistors der Basiskontakt (58) des PNP-(bzw. NPN)-Transistors gebildet wird.

8. Lateraler PNP-(bzw. NPN)-Transistor mit einer Emitter-, einer Basis- und einer Kollektorzone in einem N-(bzw. P)-leitenden monokristallinen Silicium-Bereich, welcher in einem Halbleitersubstrat angeordnet und durch eine dielektrische Isolationszone isoliert ist, dadurch gekennzeichnet,

daß die Isolationszone sich mit einem Abschnitt teilweise in den Silicium-Bereich hinein erstreckt und daß die Emitterzone über diesem Abschnitt liegt.

9. Integrierte Halbleiterschaltung mit einem Substrat (30), einer N-(bzw. P)-leitenden Epitaxieschicht (34) auf dem Substrat und einer an der Trennfläche zwischen der Epitaxieschicht und dem Substrat liegenden $N^+$ (bzw. $P^+$)-leitenden Schicht (32) bei welcher gegeneinander durch dielektrische Isolationszonen (42, 44) isolierte, aus monokristallinem Silicium bestehenden Zonen vorhanden sind, in denen jeweils ein lateraler PNP-(bzw. NPN)-Transistor bzw. ein vertikaler NPN-(bzw. PNP)-Transistor angeordnet ist, dadurch gekennzeichnet, daß die dielektrische Isolationszone sich zum Teil in die $N^+$-(bzw. $P^+$)-leitende Schicht (32) hineinstreckt und der Emitter des Lateraltransistors über diesem Teil der Isolationszone liegt.

10. Integrierte Schaltung nach Anspruch 9, dadurch gekennzeichnet, daß die Dicke der in die aus monokristallinem Silicium bestehende Zone hineinragenden dielektrischen Isolation etwa 1 bis 3 Mikrometer beträgt, und daß die Abmessungen des Emitters des lateralen Transistors etwa 1 × 1 bis 3 × 3 Mikrometer betragen.

## Revendications

1. Procédé pour fabriquer des transistors latéraux PNP (ou NPN) à gain élevé dans un semi-conducteur, caractérisé par:

la formation d'une première couche (32) de conductivité $N^+$ (ou $P^+$) dans un semi-conducteur; la croissance épitaxiale d'une seconde couche de silicium monocristallin (34) de conductivité N (P) sur la première couche; la production de cavités dans les seconde et première couches à l'aide d'un décapage par ions réactifs dans les régions du semi-conducteur où l'on doit former une région d'isolement diélectrique qui isole des régions de la seconde couche; la vitesse de décapage du processus de décapage par ions réactifs étant choisie de telle sorte que, de préférence, la première couche (32) est décapée de telle sorte qu'il se produit un décapage latéral ou affouillement (40) sous la seconde couche (34),

le remplissage des cavités avec un matériau diélectrique (44) de telle sorte que du matériau diélectrique est déposé en-dessous des régions affouillées sous la seconde couche,

la formation simultanée des régions d'émetteur (50) et de collecteur (52) de conductivité P (ou N), la région d'émetteur étant formée dans la partie du silicium monocristallin sous laquelle se trouve l'isolation diélectrique de telle sorte qu'il n'y a pas une jonction verticale entre la région d'émetteur de conductivité P (ou N) et la région enterrée de conductivité $N^+$ (ou $P^+$), et

la formation de contacts électriques (72, 74, 76) avec les régions d'émetteur, de base et de collecteur pour réaliser un transistor latéral PNP (ou NPN).

2. Procédé selon la revendication 1, caractérisé en ce qu'on forme dans le semi-conducteur une région de conductivité $N^+$ (ou $P^+$) pour le contact de base du transistor PNP (ou NPN).

3. Procédé selon la revendication 1, caractérisé en ce que le matériau diélectrique sous la seconde couche (34) a une épaisseur d'environ 1 à 3 micromètres.

4. Procédé selon la revendication 1, caractérisé en ce que le décapage par ions réactifs a lieu dans une atmosphère de chlore-argon.

5. Procédé selon la revendication 4, caractérisé en ce que le chlore est utilisé dans l'atmosphère avec une pression comprise entre 0,00266 et 0,00665 millibars et avec un pourcentage de 2 à 15%, et en ce que la vitesse de décapage est comprise entre environ 0,07 et 20 micromètres/minute.

6. Procédé selon la revendication 1, caractérisé en ce que les dimensions de la région d'émetteur sont comprises entre environ 1 × 1 et 3 × 3 micromètres.

7. Procédé selon la revendication 1, caractérisé en ce qu'on forme, simultanément avec les transistors latéraux PNP (ou NPN), un transistor vertical NPN (ou PNP) dans au moins une autre région de silicium isolée, en produisant simultanément avec l'émetteur (60) du transistor NPN (ou PNP), le contact de base (58) du transistor PNP (ou NPN).

8. Transistor latéral PNP (ou NPN) comportant une région d'émetteur, une région de base et une région de collecteur dans une région de silicium monocristallin de conductivité N (ou P); ces régions sont disposées dans un substrat semi-conducteur et isolées par une région d'isolement diélectrique, ledit transistor étant caractérisé en ce qu'une partie de la région d'isolement s'étend partiellement dans la région de silicium et en ce que la région d'émetteur est située au-dessus de cette partie.

9. Circuit semi-conducteur intégré comportant un substrat (30), une couche épitaxiale (34) de conductivité N (ou P) sur le substrat et une couche (32) de conductivité $N^+$ (ou $P^+$) située à l'interface entre la couche épitaxiale et le substrat, dans lequel sont prévues des régions de silicium monocristallin, isolées les unes des autres, par des régions d'isolement diélectrique (42, 44), lesdites régions comportant chacune un transistor latéral PNP (ou NPN) ou un transistor vertical NPN (ou PNP), circuit caractérisé en ce que la région d'isolement diélectrique s'étend partiellement dans la couche (32) de conductivité $N^+$ (ou $P^+$) et en ce que l'émetteur du transistor latéral se trouve au-dessus de cette partie de la région d'isolement.

10. Circuit intégré selon la revendication 9, caractérisé en ce que l'épaisseur de l'isolement diélectrique pénétrant dans la région de silicium monocristallin est comprise entre environ 1 et 3 micromètres, et en ce que les dimensions de l'émetteur du transistor latéral sont comprises entre environ 1 × 1 et 3 × 3 micromètres.

**Claims**

1. Method of making a lateral PNP (or NPN) transistor with high current amplification in a semiconductor body, characterized by forming a first $N^+$ (or $P^+$) conducting layer (32) in a semiconductor body,

epitaxially growing a second N (or P) conducting monocrystalline silicon layer (34) on the first layer,

forming recesses through the second and first layer, by reactive ion-etching, in those regions of the semiconductor body where a dielectric isolation region for the isolation of regions of the second layer is to be formed, the etching rate of the reactive ion etching being selected in such a manner that the first layer (32) is etched preferentially to provide sub-etching (40) of the second layer (34),

filling the recesses with a dielectric material (44) such that dielectric material is deposited under the sub-etched regions of the second layer,

simultaneously forming P (or N) emitter and collector regions (50, 52), the emitter region (50) being formed in that part of the monocrystalline silicon under which the dielectric isolation has been provided, so that between the P (or N) emitter region and the buried $N^+$ (or $P^+$) region there is no vertical junction, and

forming electrical contacts (72, 74, 76) to the emitter, base and collector regions to form a lateral PNP (or NPN) transistor.

2. Method as claimed in claim 1, characterized in that for the base contact in the semiconductor body an $N^+$ (or $P^+$) region is formed.

3. Method as claimed in claim 1, characterized in that the dielectric material under the second layer (34) is approximately 1 to 3 mi- crometers thick.

4. Method as claimed in claim 1, characterized in that the reactive ion-etching is accomplished in a chlorine-argon atmosphere.

5. Method as claimed in claim 4, characterized in that the chlorine in the atmosphere has a pressure of 0.00266 to 0.00665 mbar with a percentage of 2 to 15%, and the etching speed is between approximately 0.07 and 20 micrometers per minute.

6. Method as claimed in claim 1, characterized in that the dimensions of the emitter zone are approximately $1 \times 1$ to $3 \times 3$ micrometers.

7. Method as claimed in claim 1, characterized in that simultaneously with the lateral PNP (or NPN) transistors a vertical NPN (or PNP) transistor is formed in at least one further isolated silicon zone, and in that simultaneously with the emitter (60) of the NPN (or PNP) transistor the base contact (58) of the PNP (or NPN) transistor is formed.

8. Lateral PNP (or NPN) transistor with an emitter, base, and collector region in an N (or P) monocrystalline silicon region arranged on a semiconductor substrate and isolated by means of a dielectric isolation region, characterized in that the isolation region partially extends with one sector into the silicon region, and the emitter region is located above that sector.

9. Integrated semiconductor circuit with a substrate (30), an N (or P) epitaxial layer (34) on the substrate, and an $N^+$ (or $P^+$) conducting layer (32) located at the interface between the epitaxial layer and the substrate, wherein regions are provided which are mutually isolated by dielectric isolation regions (42, 44), and which consist of monocrystalline silicon, wherein one respective PNP (or NPN) transistor, or a vertical NPN (or PNP) transistor is arranged, characterized in that the dielectric isolation region partially extends into the $N^+$ (or $P^+$) conducting layer (32), and the emitter of the lateral transistor is located above this part of the isolation region.

10. Integrated circuit, as claimed in claim 9, characterized in that the thickness of the dielectric isolation extending into the region consisting of monocrystalline silicon is approximately 1 to 3 micrometers, and the dimensions of the emitter of the lateral transistor are approximately $1 \times 1$ to $3 \times 3$ micrometers.

## FIG. 1

## FIG.2

## FIG.3

## FIG. 4

## FIG. 5

## FIG. 6